Europäisches Patentamt

European Patent Office

Office européen des brevets

(19)

(11) Veröffentlichungsnummer: **0 200 956**
**B1**

(12) **EUROPÄISCHE PATENTSCHRIFT**

(45) Veröffentlichungstag der Patentschrift:
**11.10.89**

(51) Int. Cl.⁴: **G01R 33/035,** H01R 4/68

(21) Anmeldenummer: **86105125.8**

(22) Anmeldetag: **14.04.86**

(54) Vorrichtung zur Messung schwacher Magnetfelder.

(30) Priorität: **26.04.85 DE 3515217**

(43) Veröffentlichungstag der Anmeldung:
**17.12.86 Patentblatt 86/46**

(45) Bekanntmachung des Hinweises auf die Patenterteilung:
**11.10.89 Patentblatt 89/41**

(84) Benannte Vertragsstaaten:
**DE FR IT NL**

(56) Entgegenhaltungen:
EP-A- 0 111 827
DE-A- 1 962 231
US-A- 3 631 380

IBM TECHNICAL DISCLOSURE BULLETIN, Band 25,
Nr. 3B, August 1982, Seiten 1701-1702, New York, US;
H.R. BICKFORD et al.: "Flexible I/O cable to thin film
connector"

(73) Patentinhaber: **Siemens Aktiengesellschaft,
Wittelsbacherplatz 2, D-8000 München 2(DE)**

(72) Erfinder: **Hoenig, Eckhardt, Dr., Palmstrasse 1a,
D-8520 Erlangen(DE)**
Erfinder: **Weisse, Hanns-Jörg, Görlitzer Strasse 16,
D-8520 Erlangen(DE)**

## Beschreibung

Die Erfindung bezieht sich auf eine Vorrichtung zur Messung schwacher Magnetfelder mit einer Vielzahl von supraleitenden Verbindungen zwischen einem SQUID-Array, das auf einem mit Kontaktflächen (Kontaktpads) versehenen Substrat angeordnet ist, und einem Gradiometer-Array.

Es ist bekannt, zur Messung schwacher, sich ändernder Magnetfelder, beispielsweise in einem Feldstärkebereich unter $10^{-10}$ T, insbesondere unter $10^{-12}$ T, supraleitende Quanten-Interferenz-Elemente zu verwenden, die bekannt sind unter der Bezeichnung "SQUID" (superconducting quantum interference device). Diese Elemente werden vorzugsweise verwendet in der medizinischen Technik, insbesondere in der Magnetokardiographie, bei der Magnetfelder des Herzens in der Größenordnung von etwa 50 pT gemessen werden sowie in der Magnetoenzephalographie, bei der Magnetfelder des Gehirns in der Grössenordnung von etwa 0,1 pT gemessen werden. Die Vorrichtung besteht im wesentlichen aus einer Detektorspule, die zusammen mit einer Koppelspule einen Flußtransformator bildet, der zusammen mit dem SQUID innerhalb eines Dewar-Gefäßes in flüssigem Helium angeordnet ist. Dem SQUID ist zur Signalerfassung und -verarbeitung eine Elektronik zugeordnet. Da die zu messenden Magnetfelder bis zu sechs Größenordnungen kleiner sind als äußere Störfelder, sind entsprechende Abschirmungen erforderlich. Wegen seiner größeren Empfindlichkeit kann ein DC-SQUID (direct-current-SQUID) verwendet werden, das zwei Josephsonkontakte enthält. Die Detektorspule bildet mit einer zugeordneten Kompensationsspule ein sogenanntes Gradiometer. Mit Gradiometern nullter, erster oder höherer Ordnung kann das im Gradiometerbereich noch inhomogene biomagnetische Nahfeld selektiv erfaßt werden (Ref. Sci. Instrum. 53 (12), Dec. 1982, Seiten 1815 bis 1845).

Um eine räumliche Feldverteilung zu erhalten, muß zeitlich nacheinander an verschiedenen Orten des zu untersuchenden Bereiches gemessen werden. Dann besteht aber die Schwierigkeit, daß über die dazu erforderliche Meßzeit die Kohärenz der Felddaten nicht mehr gegeben ist und sich außerdem klinisch unzumutbare Meßzeiten ergeben. Man ist deshalb dazu übergegangen, mit Vorrichtungen zu messen, die mehrere parallele Meßkanäle enthalten (Physica 107 B (1981), Seiten 29, 30 North Holland Publ. Comp.).

In einer Ausführungsform einer Vorrichtung der eingangs genannten Art (EP-A 0 111 827) mit einem Magnetometer- oder Gradiometer-Array, das eine größere Anzahl, beispielsweise wenigstens 10, vorzugsweise mehr als 30 Gradiometerspulen enthält, muß somit auch eine Vielzahl von Leitern mit den zugeordneten Koppelspulen eines entsprechenden SQUID-Arrays verbunden werden.

In der bekannten Ausführungsform als DC-SQUID kann das SQUID zusammen mit seiner Koppelspule als Dünnfilmtransformator ausgeführt werden, bei dem die flachen spiralförmigen Windungen der Koppelspule über dem SQUID angeordnet sind. Mit dieser Ausführung erhält man eine gute magnetische Kopplung (IEEE Transact. on Magnetics, Vol. MAG-17, No. 1, Jan. 1981, Seiten 400 bis 403).

Der Erfindung liegt nun die Aufgabe zugrunde, eine Ausführungsform einer Vorrichtung zur Messung schwacher Magnetfelder anzugeben, bei der eine Vielzahl von Koppelspulen des SQUID-Arrays mit einer entsprechenden Anzahl von Magnetometer- oder Gradiometerspulen auf begrenztem Raum, reproduzierbar und zuverlässig sowie mit geringer Induktivität miteinander verbunden sind.

Diese Aufgabe wird erfindungsgemäß gelöst mit den Merkmalen des Anspruchs 1. Die in besonderer Weise geformten Kontaktfedern aus supraleitendem Material, vorzugsweise Niob, werden zu einem Paket zusammengesetzt und in der Nut, die vorzugsweise eine V-Nut sein kann, des Justierblockes geführt. Die einzelnen Federn werden durch Bekleben mit einer elektrisch isolierenden Folie, vorzugsweise einer Kunststoffolie, oder einer elektrisch isolierenden Zwischenlage gegeneinander isoliert. Ihre Dicke einschließlich der Isolation bestimmt den Abstand der Druckkontakte, der durch die Größe und Gestaltung der Kontaktpads auf dem Substrat bestimmt wird. Durch eine versetzte Anordnung benachbarter Kontaktpads läßt sich die Packungsdichte des Kontaktkamms entsprechend erhöhen.

In ähnlicher Weise können im Kontaktkamm einander benachbarte Federkontakte jeweils abwechselnd an ihren den Gradiometerleitungen zugewandten Enden mit Anschlußzungen verschiedener Länge versehen sein. Ferner können die Anschlußzungen für die Supraleiter in der Höhe gegeneinander versetzt sein, so daß zwischen benachbarten Kontaktfedern Platz für die supraleitenden Anschlußleitungen geschaffen wird.

In einer besonderen Ausführungsform der Vorrichtung kann unterhalb der Federkontakte eine magnetische Abschirmung aus einem supraleitenden Grundkörper vorgesehen sein, auf dem das Halbleitersubstrat angeordnet ist und der sich auch noch unterhalb des Justierblockes erstreckt. Diese Abschirmung kann vorzugsweise zugleich als Groundplane ausgebildet sein.

In einer Ausführungsform der Vorrichtung mit einem Gradiometer- oder Magnetometer-Array, dessen Spulen aus supraleitenden Dünnschichtleiterbahnen auf Folien-Trägern bestehen, kann vorzugsweise zwischen den Federkontakten und den Dünnschichtleiterbahnen eine supraleitende Übergangsverbindung vorgesehen sein, die sowohl eine Verbindung eines Supraleiters mit dem Federkontakt als auch eine Verbindung des Supraleiters mit der Dünnschichtleiterbahn ermöglicht.

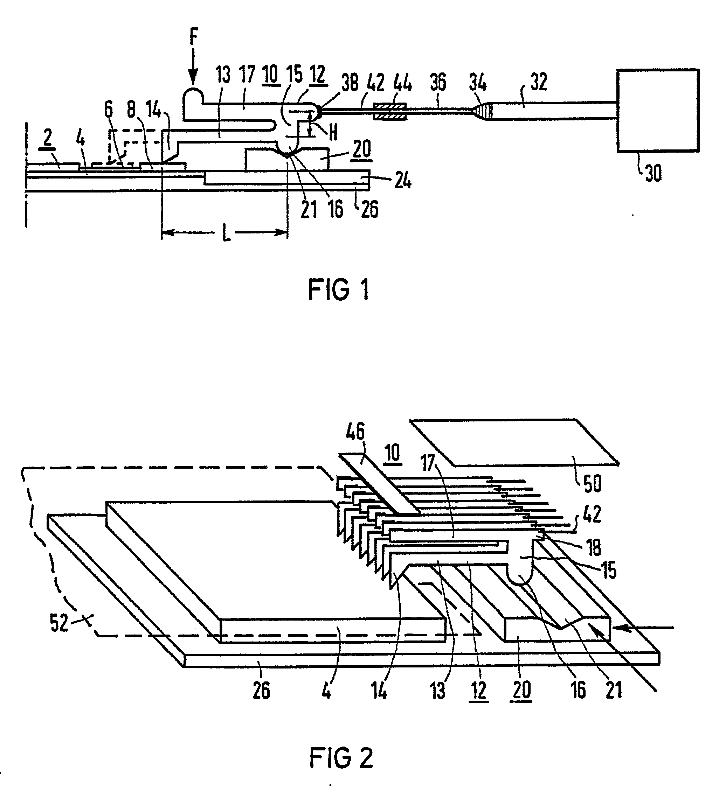

Zur weiteren Erläuterung der Erfindung wird auf die Zeichnung Bezug genommen, in der ein Ausführungsbeispiel einer Vorrichtung nach der Erfindung schematisch veranschaulicht ist. Figur 1 zeigt eine einzelne Leitungsverbindung zwischen einem SQUID-Array und einem Gradiometer-Array. In Figur 2 ist eine Ausführungsform eines Kontaktkamms als perspektivische Darstellung schematisch veranschaulicht.

In der Ausführungsform einer Vorrichtung zur Messung schwacher Magnetfelder nach Figur 1 soll eine größere Anzahl, vorzugsweise mindestens 10 SQUIDS, von denen in der Figur lediglich eines angedeutet und mit 2 bezeichnet ist, zusammen mit ihren Koppelspulen und gegebenenfalls noch ihren Modulationsspulen als Dünnfilmstruktur auf einem Substrat 4 angeordnet werden. Das Substrat kann vorzugsweise aus Halbleitermaterial, insbesondere aus Silicium, bestehen. Die elektrischen Anschlußleiter der SQUIDs 2 sowie ihrer zugeordneten Koppelspulen sind jeweils über einen supraleitenden Verbindungsleiter 6 mit einem großflächigen supraleitenden Anschlußkontakt, einen sogenannten Kontaktpad 8 verbunden, der beispielsweise aus Niob bestehen kann.

Diesem Kontaktpad 8 ist ein Federkontakt 12 eines Kontaktkammes 10 zugeordnet. Der im wesentlichen U-förmige Federkontakt 12 enthält einen unteren Schenkel 13, der an seinem freien Ende mit einer Nase 14 versehen ist, deren Ende als Druckkontakt für das Kontaktpad 8 vorgesehen ist. Der mittlere Schenkel 15 des Federkontakts 12 ist in der gleichen Richtung wie die Nase 14 mit einem Vorsprung 16 versehen, der in einer senkrecht zu den Flachseiten des Federkontakts 12 und parallel zur Ebene der Kontaktpads 8 verlaufenden Nut 21 eines Justierblockes 20 aus elektrisch isolierendem Material gelagert ist. Auf das Ende des dritten Schenkels 17 des Federkontakts 12 wirkt eine Kraft F parallel zu den Flachseiten des Federkontakts 12 und senkrecht zur Oberfläche des Kontaktpads 8. Diese Kraft ist in der Figur durch einen Pfeil angedeutet. Der Justierblock 20 ist auf einer Printplatte 24 angeordnet. An der unteren Flachseite der Printplatte 24 ist eine Abschirmung 26 aus supraleitendem Material, beispielsweise Niob, vorgesehen. Das Substrat 4 ist in einen nicht näher bezeichneten Auschnitt der Printplatte 24 eingesetzt.

In einer Ausführungsform der Vorrichtung zur Messung schwacher Magnetfelder mit einen Gradiometer- oder Magnetometer-Array 30, dessen Spulen aus supraleitenden oder supraleitend beschichteten Dünnschichtleiterbahnen auf Folienträgern bestehen, ist es schwierig, die supraleitenden Federkontakte 12, die im allgemeinen aus Niob bestehen, mit den Dünnschichtleiterbahnen 32 zu verbinden. Diese Dünnschicht-Leiterbahnen können vorzugsweise auf beiden Flachseiten eines Trägers aus Kunststoff, vorzugsweise Polyimid (Capton) oder glasfaserverstärktem Kunststoff (GFK), wie beispielsweise Epoxidharz, aufgebracht sein. Die Herstellung solcher Leiterbahnen kann nach bekannten Strukturierungsverfahren, beispielsweise Photoresist-Ätztechnik, aus metallkaschierten Kunststoffträgern erfolgen. Die metallischen Leiterbahnen mit einer Breite von beispielsweise 50 bis 300 µm und einer Dicke von beispielsweise etwa 10 bis 50 µm können beispielsweise aus Manganin, Kupfer oder Bronze bestehen. Diese Leiterstreifen erhalten eine supraleitende Oberflächenschicht, die vorzugsweise aus einem Blei/Zinn-Lot bestehen kann. Diese Leiterbahn 32 kann mit Hilfe einer Lötverbindung 34 mit einem Metalldraht 36 verbunden werden, der beispielsweise aus Bronce bestehen kann und mit einem supraleitenden Überzug versehen ist, der vorzugsweise aus Blei/ Zinn bestehen kann. Der Federkontakt 12 wird dann mit Hilfe eine Schweißverbindung 38 mit einem supraleitenden Draht 42 versehen, der beispielsweise aus Niob bestehen kann, und mit Hilfe eines Quetschkontakts (crimp contact) mit dem Metalldraht 36 verbunden werden kann. Der Quetschkontakt erfolgt mit Hilfe einer aufgeschobenen Hülse 44 aus supraleitendem Material, beispielsweise Niob.

In der Ausführungsform eines Kontaktkamms 10 nach Figur 2 ist eine größere Anzahl von Federkontakten 12, von denen in der Figur nur 8 dargestellt sind und die mit einer in der Figur nicht dargestellten Isolierung versehen sind, mit ihren Flachseiten derart aneinandergereiht, daß sie ein Federpaket bilden. Die Nasen 14 ihrer unteren Schenkel 13 berühren jeweils ein in der Figur nicht dargestelltes Kontaktpad auf der Oberfläche des Substrats 4, das auf der Abschirmung 26 angeordnet ist. Die Vorsprünge 16 der mittleren Schenkel 15 können beispielsweise halbkreisförmig geformt sein. In der dargestellten Ausführungsform ist die Nut des Justierblockes 20 mit einem Dreiecksprofil versehen. Der Justierblock 20 ist auf der Printplatte 24, die in Figur 2 zur Vereinfachung nicht dargestellt ist, sowohl in der Richtung parallel zu den Schenkeln 13 und 17 der Federkontakte 12 als auch senkrecht zu den Flachseiten der Federkontakte beweglich, wie es durch entsprechende Pfeile angedeutet ist. Er wird mit dem Kontaktkamm 10 durch eine Justiervorrichtung fixiert, sobald die Nasen 14 der Federkontakte 12 auf den ihnen zugeordneten und in der Figur zur Vereinfachung nicht dargestellten Kontaktpads aufliegen. In dieser Lage wird über den oberen Schenkeln 17 eine Druckplatte 46 angeordnet, deren Verschraubung in der Figur nicht dargestellt ist und deren Andruckkraft den Kontaktdruck der Federkontakte 12 auf den Kontaktpads 8 bestimmen.

Die Federkontakte 12 können an ihrem mittleren Schenkel 15 jeweils mit Anschlußfahnen 18 vorzugsweise verschiedener Länge versehen sein, an denen der supraleitende Draht 42 angeschweißt werden kann. Durch die verschiedenen Längen erhält man jeweils Platz für die Schweißverbindung.

Die Länge L der unteren Schenkel 13 der Federkontakte 12 kann beispielsweise 15 mm und die mittlere Höhe H ihres mittleren Schenkels kann beispielsweise etwa 3 mm betragen. Ihre Dicke d einschließlich ihrer elektrisch isolierenden Auflage kann beispielsweise 0,5 mm betragen. Sie wird bestimmt durch die Breite der Kontaktpads 8 auf dem Substrat 4. Die Breite des Federkamms 10 kann dadurch vermindert werden, daß die Kontaktpads 8 auf dem Substrat 4 jeweils gegeneinander versetzt werden. In dieser Ausführungsform erhält der Kontaktkamm 10 Federkontakte 12 mit jeweils abwechselnd verschiedener Länge seiner unteren Schenkel 13, wie es in der Figur 1 gestrichelt angedeutet ist. In dieser Ausführungsform kann bei gleicher Breite des Substrats 4 eine größere Anzahl von Kontaktpads 8 jeweils über eine der Kontaktfedern 12 mit der Dünnschichtleiterbahn 32 einer der Spulen des Gradiometers 30 verbunden werden.

Die Federkontakte 12 des Kontaktkamms 10 können zweckmäßig mit einer zusätzlichen Abschirmung 50 versehen sein, die in einer besonderen Ausführungsform der Vorrichtung zugleich als Groundplane ausgeführt sein kann. Sie kann in dieser Ausführungsform zugleich als gemeinsamer Anschlußleiter für die Rückleitungen der Spulen des Gradiometers 30 dienen. Sie kann ferner lediglich als Sammelkontakt für diese Rückführungen vorgesehen sein und über eine der Kontaktfedern 12 mit einem Kontaktpad 8 des Substrats 4 verbunden sein, der dann an Masse gelegt sein kann. Die zusätzliche Abschirmung 50 kann zweckmäßig mit der Druckplatte 46 auf dem Kontaktkamm 10 befestigt werden, dessen Schraubverbindung zur Vereinfachung in der Figur nicht dargestellt ist.

In einer besonderen Ausführungsform der Anordnung kann für die SQUIDs mit ihren Verbindungsleitern und Kontaktpads noch eine weitere Abschirmung 52 vorgesehen sein, die oberhalb des Substrats 4 angeordnet wird, wie es in der Figur gestrichelt angedeutet ist.

**Patentansprüche**

1. Vorrichtung zur Messung schwacher Magnetfelder mit einer Vielzahl von supraleitenden Verbindungen zwischen einem SQUID-Array (2), das auf einem mit Kontaktflächen (8) versehenen Substrat (4) angeordnet ist, und einem Gradiometer-Array (30), **dadurch gekennzeichnet**, daß als Teil der supraleitenden Verbindungen ein Kontaktkamm (10) vorgesehen ist, der aus flachen im wesentlichen U-förmigen Federkontakten (12) besteht, die elektrisch gegeneinander isoliert mit ihren Flachseiten parallel zueinander und senkrecht zur Oberfläche der Kontaktflächen (8) zu einem Paket zusammengesetzt sind, und daß der eine Schenkel (13) der Federkontakte (12) mit einer Nase (14) versehen ist, die als Druckkontakt für eines der Kontaktflächen (8) vorgesehen ist, und daß der mittlere Schenkel (15) in der gleichen Richtung wie die Nase (14) mit einem Vorsprung (16) versehen ist, der in einer senkrecht zu den Flachseiten der Federkontakte (12) und parallel zur Ebene der Kontaktflächen (8) verlaufenden Nut (21) eines Justierblockes (20) aus elektrisch isolierendem Material gelagert ist, und daß dem dritten Schenkel (17) eine Druckplatte (46) zugeordnet ist, deren Kraft (F) parallel zu den Flachseiten der Federkontakte (12) und senkrecht zur Oberfläche der Kontaktflächen (8) gerichtet ist.

2. Vorrichtung nach Anspruch 1, **dadurch gekennzeichnet**, daß jeweils abwechselnd Federkontakte (12) verschiedener Länge (L) vorgesehen sind, deren Nasen (14) in der Ebene ihrer Flachseiten und parallel zur Oberfläche der Kontaktflächen (8) gegeneinander versetzt sind.

3. Vorrichtung nach Anspruch 1 oder 2, **dadurch gekennzeichnet**, daß unterhalb der Federkontakte (12) eine magnetische Abschirmung aus einem supraleitenden Grundkörper (26) vorgesehen ist, auf dem das Substrat (4) angeordnet ist und der sich auch noch unterhalb des Justierblockes (20) erstreckt.

4. Vorrichtung nach einem der Ansprüche 1 bis 3, **dadurch gekennzeichnet**, daß eine zusätzliche Abschirmung (50) oberhalb der Federkontakte (12) aus einem suspraleitenden Material vorgesehen ist, die gemeinsam mit der Druckplatte (46) befestigt ist.

5. Vorrichtung nach Anspruch 4, **dadurch gekennzeichnet**, daß die zusätzliche Abschirmung (50) als Erdungsebene für einen Teil der supraleitenden Verbindungen vorgesehen ist, die gemeinsam über einen der Federkontakte (12) mit einem der Kontaktflächen (8) verbunden sind.

6. Vorrichtung nach einem der Ansprüche 1 bis 5, bei welcher die Spulen des Gradiometer- oder eines Magnetometer-Arrays (30) aus supraleitenden Dünnschichtleiterbahnen (32) auf Folien-Trägern bestehen, **dadurch gekennzeichnet**, daß jeweils zwischen einem der Federkontakte (12) und der Dünnschichtleiterbahn (32) eine supraleitende Übergangsverbindung vorgesehen ist mit einem Supraleiterdraht (42), der durch eine Punktschweißung (38) mit dem Federkontakt (12) und durch einen Quetschkontakt (44) mit einem Leiter (36) aus normalleitendem Material und supraleitender Beschichtung verbunden ist, der mittels einer Lötverbindung (34) an die Dünnschichtleiterbahn (32) angeschlossen ist.

**Claims**

1. Apparatus for measuring weak magnetic fields, having a plurality of superconducting connections between a SQUID array (2) which is arranged on a substrate (4) provided with contact areas (8), and a gradiometer array (30), characterised in that, as part of the superconducting connections, a contact comb (10) is provided which consists of flat, substantially U-shaped spring contacts (12) which are assembled into a packet in such a way that they are electrically insulated from each other, with their flat sides parallel to each other, and are perpendicular to the surface of the contact areas (8), and in that one limb (13) of the spring contacts (12) is provided with a lug (14) which is intended as pressure contact for one of the contact areas (8), and in that the middle limb (15) is provided with a projection (16) in the same direction as the lug (14), which projection (16) is supported in a groove (21) of an adjusting block (20) of electrically insulating material, which groove (21) runs perpendicular to the flat sides of the spring contacts (12) and parallel to the plane of the contact areas (8), and in that a pressure plate (46) is associated with the third limb (17), the force (F) of which pressure plate (46) is directed parallel to the flat sides of the spring contacts (12) and perpendicular to the surface of the contact areas (8).

2. Apparatus according to claim 1, characterised in that there are provided respectively alternate spring contacts (12) of different lengths (L), the lugs (14) of which are offset with respect to each other in the plane of their flat sides and parallel to the surface of the contact areas (8).

3. Apparatus according to claim 1 or 2, characterised in that beneath the spring contacts (12) a magnetic screen of a superconducting ground substance (26) is provided, on which the substrate (4) is arranged, and which also extends beneath the adjusting block (20).

4. Apparatus according to one of the claims 1 to 3, characterised in that an additional screen (50) of a superconducting material is provided above the spring contacts (12), which screen is attached jointly with the pressure plate (46).

5. Apparatus according to claim 4, characterised in that the additional screen (50) is provided as an grounding plane for a part of the superconducting connections, which are connected jointly by way of one of the spring contacts (12) to one of the contact areas (8).

6. Apparatus according to one of the claims 1 to 5, in which the coils of the gradiometer array or of a magnetometer array (30) consist of superconducting thin-layer printed conductors (32) on foil supports, characterised in that, between one of the spring contacts (12) and the thin-layer printed conductor (32) in each case, a superconducting adaptor connection is provided, with a superconducting wire (42) which is connected by means of a spot weld (38) to the spring contact (12), and by means of a crimp contact (44) to a conductor (36) of normal-conducting material with a superconducting coating, which conductor (36) is joined by means of a soldered connection (34) to the thin-layer printed conductor (32).

**Revendications**

1. Dispositif pour mesurer des champs magnétiques faibles, avec un grand nombre de liaisons supraconductrices entre un arrangement de squids (2) qui est disposé sur un substrat (4) pourvu de surfaces de contact (8), et un arrangement de gradiomètres (30), caractérisé par le fait qu'il est prévu, en tant que liaisons supraconductrices, un peigne à contacts (10) qui est constitué par des contacts à ressort (12) plats qui ont, pour l'essentiel, la forme d'un U, qui sont isolés électriquement entre eux et qui sont assemblés en un bloc, parallèlement entre eux par leurs côtés plats et perpendiculairement à la face supérieure des surfaces de contact (8), qu'une première branche (13) des contacts à ressort (12) est pourvue d'un bec (14) qui est prévu en tant que contact de pression pour l'une des surfaces de contact (8), que la branche médiane (15) est pourvue, dans la même direction que le bec (14), d'un appendice (16) qui est monté dans un gorge (21) d'un bloc d'ajustage (20) fait avec un matériau électriquement isolant, ladite gorge s'étendant perpendiculairement aux côtés plats des contacts à ressort (12) et parallèlement qu plan des surfaces de contact (8), et qu'à la troisième branche (17) est associée une plaque de pression (46) dont la force (F) est dirigée parallèlement aux côtés plats des contacts à ressort (12) et perpendiculairement à la face supérieure des surfaces de contact (8).

2. Dispositif selon la revendication 1, caractérisé par le fait que sont prévus en alternance des contacts à ressort (12) de différentes longueures (L), dont les becs (14) sont décalés entre eux dans le plan de leurs côtés plats et parallèlement à la face supérieure des surfaces de contact (8).

3. Dispositif selon la revendication 1 ou 2, caractérisé par le fait qu'il est prévu en dessous des contacts à ressort (12) un écran magnétique en un corps de base supraconducteur (26) sur lequel est disposé le substrat (4) et qui s'étend encore en dessous du bloc d'ajustage (20).

4. Dispositif selon l'une des revendications 1 à 3, caractérisé par le fait qu'il est prévu au-dessus des contacts à ressort (12) un écran supplémentaire (50), en un matériau supraconducteur, qui est fixé ensemble avec la plaque de pression (46).

5. Dispositif selon la revendication 4, caractérisé par le fait que l'écran supplémentaire (50) est prévu en tant que de mise à la terre pour une partie des liaisons supraconductrices qui sont reliées en commun avec l'une des surfaces de contact (8), par l'intermédiaire de l'un des contacts à ressort (12).

6. Dispositif selon l'une des revendications 1 à 5, dans lequel les bobines de l'arrangement de gradiomètries ou d'un arrangement de magnétométries (30) sont constituées par des pistes conductrices en couche mince et à supraconduction sur des supports de feuilles minces, caractérisé par le fait que respectivement entre l'un des contacts à ressort (12) et la piste conductrice en couche mince (32) est prévue une liaison de transition supraconductrice, avec un fil à supraconduction (42) qui est relié par un soudure par points (38) avec le contact à ressort (12) et par un contact à sertissage (44) avec un conducteur (36) fait avec un matériau à conduction normale et à revêtement à supraconduction et relié à l'aide d'une liaison à la soudure (34) à la piste conductrice en couche mince (32).

FIG 1

FIG 2